# EUROPÄISCHE PATENTSCHRIFT

(11) **EP 0 776 028 B1**
(45) Veröffentlichungstag und Bekanntmachung des Hinweises auf die Patenterteilung: **26.02.2003**
(21) Anmeldenummer: 96118052.8
(22) Anmeldetag: 11.11.1996
(51) Int. Cl.: H01L 21/265, H01L 21/329, H01L 21/331, H01L 21/332, H01L 29/32, H01L 21/322

(54) **Verfahren zum Herabsetzen der Ladungsträgerkonzentration zur Absenkung der Speicherladung in Halbleiterbauelementen durch zwei Implantationsstufen**
Process for reducing the carrier charge concentration for lowering the storage charge in semiconductor devices through two implantation steps
Procédé de réduction de la concentration de porteurs de charge produisant un effet de stockage de charge réduit dans des dispositifs à semiconducteurs, par deux étapes d'implantation

(30) Priorität: 24.11.1995 DE 19543922
(43) Veröffentlichungstag der Anmeldung: 28.05.1997
(73) Patentinhaber: Infineon Technologies AG, 81669 München (DE)
(72) Erfinder: Strack, Helmut, Dr.phil, 80804 München (DE); Porst, Alfred, Dipl.-Ing. (FH), 81249 München (DE)
(74) Vertreter: Patentanwälte Westphal, Mussgnug & Partner

(56) Entgegenhaltungen:
- EP-A- 0 013 340
- WO-A-85/01391
- US-A- 4 053 924
- PATENT ABSTRACTS OF JAPAN vol. 013, no. 268 (E-775), 20.Juni 1989 & JP 01 059949 A (HITACHI LTD;OTHERS: 01), 7.März 1989,
- INTERNATIONAL ELECTRON DEVICES MEETING, SAN FRANCISCO, DEC. 9 - 12, 1990, Nr. -, 9.Dezember 1990, INSTITUTE OF ELECTRICAL AND ELECTRONICS ENGINEERS, Seiten 261-264, XP000279566 TAKASHI KUROI: "SELF-GETTERING AND PROXIMITY GETTERING FOR BURIED LAYER FORMATION BY MEV ION IMPLANTATION"
- S.M.Sze VLSI Technology, second edition, McGraw-Hill Company (1988), Seite 356-358

## Beschreibung

In bipolaren Halbleiterbauelementen wie Dioden, IGBT, Thyristoren und GTO-Thyristoren wird während der Durchlaßphase das hochohmige Basisgebiet von Ladungsträgern beider Polaritäten überschwemmt. Damit wird die Leitfähigkeit im Basisgebiet erhöht. Beim Abschalten des Halbleiterbauelements muß diese gespeicherte Ladung wieder entfernt werden, was zu einer entsprechenden Verlustarbeit bei dem Schaltvorgang führt. Außerdem wird der Ausschaltvorgang verlängert.

Durch die Dotierung des Halbleiterkörpers mit Gold oder Platin kann die Lebensdauer der Minoritätsladungsträger reduziert werden. Da diese Rekombinationszentren im allgemeinen gleichmäßig im Halbleiterkörper verteilt sind, geht mit der Schwermetalldotierung eine Reduktion der Trägerdichte im Mittelgebiet einher ("Hängekurve"). Dies führt zu einem Anstieg des Durchlaßwiderstandes.

Die Trägerspeicherladung kann auch durch Bestrahlen des Halbleiterkörpers mit Protonen oder Heliumkernen verringert werden. Man vergleiche hierzu z.B. Wondrak et al, Physica 129B (1985), Seiten 322 bis 326, Silber et al, IEDM, 1985, Seiten 162 bis 165 und Akiyama et al, ISPSD 1991, Seiten 187 bis 191. Durch die Bestrahlung mit Protonen oder Heliumkernen ist es möglich, das Kristallgitter des Halbleiterkörpers in der Nähe des pn-Übergangs zu stören. Diese Störungen wirken als Rekombinationszentren für die die Speicherladung darstellenden Ladungsträgerpaare. Die Eindringtiefe der genannten Teilchen kann durch ihre Beschleunigungsenergie relativ gut eingestellt werden. Durch dieses Verfahren wird die Rekombination in den Randgebieten, d.h. außerhalb des niedrig dotierten Basisgebiets deutlich erhöht. Die gewünschte Absenkung der Trägerkonzentration im Basisgebiet wird also durch eine Verschlechterung des Emitterwirkungsgrades erreicht.

Der Nachteil dieser Bestrahlungsverfahren besteht darin, daß zusätzlich zu den für die Herstellung der dotierten Zonen notwendigen Implantern, Quellen für Protonen bzw. Heliumkerne erforderlich sind. Da diese Quellen im allgemeinen nicht in den Herstellprozeß integrierbar sind, wird die Herstellung umständlich.

In Patent abstract of Japan JP-A-1-059949 ist ein Verfahren zur Herstellung einer Diode in einem Speicherbauelement beschrieben, wobei die Diode die Funktion eines Spannungsbegrenzers übernimmt. Das Dokument beschreibt, daß Bor zur Herstellung eines gestörten Bereiches in den PN-Übergang implantiert wird. Der gestörte Bereich wird bei einer Temperatur < 450°C getempert.

Die Erfindung bezieht sich auf ein Verfahren zum Herabsetzen der Trägerspeicherladung in einem bipolarem Halbleiterbauelement mit einem Halbleiterkörper, durch Implantation von Ionen in einen Teilbereich des Halbleiterkörpers.

Die der Erfindung zugrundeliegende Aufgabe besteht darin, das bekannte Verfahren zu vereinfachen.

Diese Aufgabe wird gelöst durch die Schritte:
a) In die Oberfläche eines Halbleiterkörpers vom ersten Leitungstyp werden durch eine erste Implantation Ionen mit einer ersten Dosis implantiert, die einen Dotierstoff vom zweiten Leitungstyp bilden,
b) der Dotierstoff wird dann bis zu einer vorbestimmten Tiefe eindiffundiert,
c) in die gleiche Oberfläche werden anschließend die gleichen Ionen durch eine zweite Implantation mit einer zweiten Dosis implantiert, die höher ist als die erste Dosis,
d) der Halbleiterkörper wird nach der zweiten Implantation bei einer Temperatur < 500°C getempert, welche niedriger ist als diejenige Temperatur, mit der die Dotierstoffe eindiffundierren.

Weiterbildungen der Erfindung sind Gegenstand der Unteransprüche.

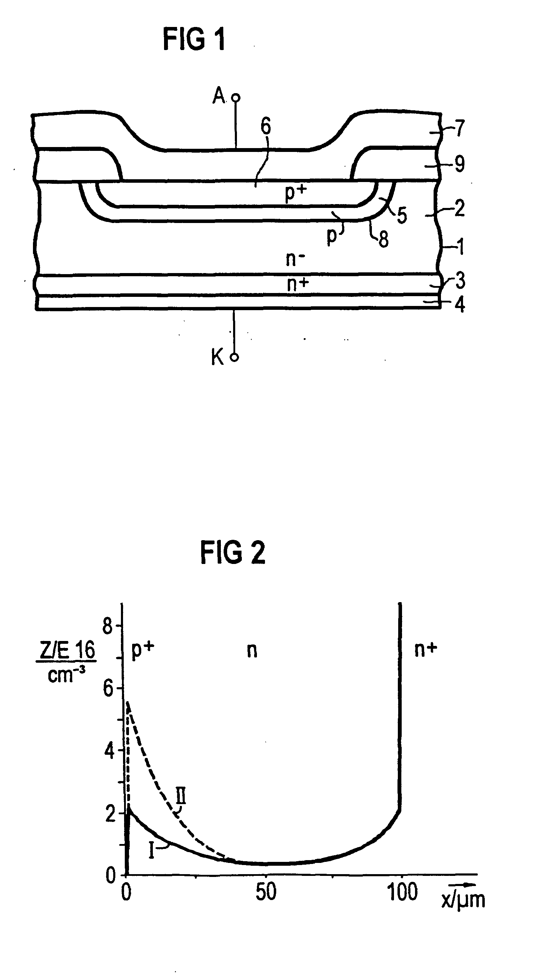

Die Erfindung wird anhand eines Ausführungsbeispiels in Verbindung mit den Figuren 1 und 2 näher erläutert. Es zeigen
- Figur 1: einen Schnitt durch eine gemäß Erfindung hergestellte Diode und
- Figur 2: die Ladungsträgerverteilung in dieser Diode während der Durchlaßphase (Kurve I) im Vergleich zu einer mit Schwermetall dotierten Diode (Kurve II).

Die Diode nach Figur 1 hat einen Halbleiterkörper mit einer schwach n-dotierten Zone 2. An die Zone 2 schließt sich eine stark dotierte Zone 3 an. Diese ist durch eine Katodenelektrode 4 kontaktiert, die mit einem Katodenanschluß K verbunden ist. In der Zone 2 ist eine p-dotierte Zone 5 eingebettet, der zwischen den Zonen 2 und 5 liegende pn-Übergang ist mit 8 bezeichnet. In die Zone 5 ist eine stark p-dotierte Zone 6 eingebettet, die bis an die anodenseitige Oberfläche des Halbleiterkörpers 1 reicht. Die Zone 6 ist über eine Metallschicht 7 kontaktiert, die mit einem Anodenanschluß A verbunden ist.

Die p-dotierte Zone 5 wird durch eine erste Implantation, z.B. mit Borionen und nachfolgender Eindiffusion hergestellt. Hierbei dient die strukturierte Isolierschicht 9 als Maske. Die Dosis der Borimplantation sollte etwas größer als die Durchbruchladung sein, die für Silizium bei etwa 10¹²cm⁻² liegt. Die implantierten Borionen werden dann auf bekannte Weise z.B. bei 1100°C bis in die gewünschte Tiefe in die Basiszone 2 eindiffundiert. Dabei entsteht der pn-Übergang 8. Mit der Diffusion heilen die durch die Implantation verursachten Gitterschäden aus, so daß die die Anodenzone bildende Zone 5 im wesentlichen störungsfrei ist.

Durch die Maske 9 wird später im Prozeßablauf in die anodenseitige Oberfläche des Halbleiterkörpers nun ein zweites Mal der gleiche Dotierstoff, z.B. Bor implantiert. Dies geschieht mit einer höheren Dosis, die z.B. zwischen 1 x 10¹³ und 1 x 10¹⁶ cm⁻² betragen kann. Durch die zweite Borimplantation entsteht ein stark gestörter Bereich 6, der innerhalb der Anodenzone 5 liegt. Die starken Störungen wirken, wie eingangs erwähnt, als Rekombinationszentren für die Ladungsträgerpaare. Diese Störungen werden nun nicht mehr vollständig ausgeheilt, da bei den nachfolgenden Prozeßschritten nur Temperaturen < 500°C vorkommen und damit Rekombinationszentren bestehen bleiben.

Als Ergebnis wird eine Ladungsträgerverteilung im Durchlaßzustand erhalten, die in Figur 2 dargestellt und mit I bezeichnet ist. Dabei ist auf der Ordinate die Ladungsträgerkonzentration und auf der Abszisse die Entfernung im Halbleiterkörper von der anodenseitigen Oberfläche aufgetragen. Es ist deutlich zu sehen, daß die Ladungsträgerkonzentration am pn-Übergang gegenüber einer herkömmlichen, mit Schwermetallatomen dotierten Dioden gering ist. Damit kann die Trägerspeicherladung deutlich abgesenkt werden. Da diese Trägerabsenkung nur wenig temperaturabhängig ist, wird auch die Speicherladung nur geringfügig mit der Temperatur anwachsen.

Die Erfindung wurde anhand einer Diode beschrieben. Es ist selbstverständlich auch möglich, auf die gleiche Weise die Trägerspeicherladung bei anderen bipolaren Halbleiterbauelementen mit schwach dotierter Basiszone wie Thyristoren und GTO-Thyristoren zu verringern.

## Patentansprüche

1. Verfahren zum Herabsetzen der Trägerspeicherladung in einem bipolarem Halbleiterbauelement mit einem Halbleiterkörper, durch Implantation von Ionen in einen Teilbereich des Halbleiterkörpers,
**gekennzeichnet durch**die Schritte:
a) In die Oberfläche eines Halbleiterkörpers (1) vom ersten Leitungstyp werden durch eine erste Implantation Ionen mit einer ersten Dosis implantiert, die einen Dotierstoff vom zweiten Leitungstyp bilden,
b) der Dotierstoff wird dann bis zu einer vorbestimmten Tiefe eindiffundiert,
c) in die gleiche Oberfläche werden anschließend die gleichen Ionen durch eine zweite Implantation mit einer zweiten Dosis implantiert, die höher ist als die erste Dosis,
d) der Halbleiterkörper wird nach der zweiten Implantation bei einer Temperatur < 500°C getempert, welche niedriger ist als diejenige Temperatur, mit der die Dotierstoffe eindiffundieren.

2. Verfahren nach Anspruch 1
**dadurch gekennzeichnet, daß** Borionen implantiert werden.

3. Verfahren nach einem der Ansprüche 1 oder 2,
**dadurch gekennzeichnet, daß** die erste Dosis 1 x 10¹² bis 5 x 10¹³ cm⁻² und die zweite Dosis 1 x 10¹³ bis 1 x 10¹⁶ cm⁻² beträgt.

## Claims

1. A method for reducing the carrier storage charge in a bipolar semiconductor device having a semiconductor body, by the implantation of ions into a sub-region of the semiconductor body,
**characterised by** the following steps:
a) ions which form a dopant of the second conductivity type are implanted by a first implantation with a first dosage into the surface of a semiconductor body (1) of the first conductivity type,
b) the dopant is then diffused to a predetermined depth,
c) the same ions are then implanted into the same surface by a second implantation with a second dosage which is higher than the first dosage,
d) after the second implantation the semiconductor body is malleablised at a temperature of < 500 °C, which is lower than that temperature at which the dopants diffuse.

2. A method according to Claim 1,
**characterised in that** the boron ions are implanted.

3. A method according to one of Claims 1 or 2,
**characterised in that** the first dosage is 1 x 10¹² to 5 x 10¹³ cm⁻² and the second dosage is 1 x 10¹³ to 1 x 10¹⁶ cm⁻².

## Revendications

1. Procédé pour réduire la charge de stockage des porteurs dans un composant à semi-conducteurs bipolaire avec un corps à semi-conducteurs en implantant des ions dans une zone partielle du corps à semi-conducteurs
**caractérisé par** les étapes suivantes :
a) dans la surface d'un corps à semi-conducteurs (1) de la première nature de conductivité, on implante au cours d'une première implantation des ions avec une première dose qui forment un dopant de la deuxième nature de conductivité,
b) le dopant est ensuite diffusé à l'intérieur jusqu'à une profondeur prédéfinie,
c) dans la même surface, on implante ensuite les mêmes ions au cours d'une deuxième implantation avec une deuxième dose qui est supérieure à la première dose,
d) après la deuxième implantation, le corps à semi-conducteurs est malléabilisé à une température de < 500 °C qui est inférieure à la température à laquelle les dopants sont diffusés à l'intérieur.

2. Procédé selon la revendication 1
**caractérisé en ce qu'**
on implante des ions de bore.

3. Procédé selon l'une des revendications 1 ou 2,
**caractérisé en ce que**
la première dose est comprise entre 1 x 10¹² et 5 x 10¹³ cm⁻² et la deuxième dose entre 1 x 10¹³ et 1 x 10¹⁶ cm⁻².
